(19) **Europäisches Patentamt / European Patent Office / Office européen des brevets**

(11) **EP 1 098 403 B1**

(12) **FASCICULE DE BREVET EUROPEEN**

(45) Date de publication et mention
de la délivrance du brevet:
**07.02.2007 Bulletin 2007/06**

(51) Int Cl.:
*H01S 3/00* *(2006.01)* *G02B 27/10* *(2006.01)*
*B23K 26/067* *(2006.01)*

(21) Numéro de dépôt: **00402848.6**

(22) Date de dépôt: **16.10.2000**

(54) **Dispositif d'élaboration d'une pluralité de faisceaux laser**

Vorrichtung zur Behandlung einer Anzahl von Laserstrahlen

Device for processing a plurality of laser beams

(84) Etats contractants désignés:
**AT BE CH CY DE DK ES FI FR GB GR IE IT LI LU MC NL PT SE**

(30) Priorité: **02.11.1999 FR 9913656**

(43) Date de publication de la demande:
**09.05.2001 Bulletin 2001/19**

(73) Titulaire: **AUTOMA-TECH**
**27100 Val de Reuil (FR)**

(72) Inventeurs:
• **Charbonnier, Serge**
**27120 Chambray (FR)**
• **Boureau, Damien**
**76000 Rouen (FR)**

(74) Mandataire: **Dronne, Guy et al**
**Cabinet Beau de Loménie,**
**158, rue de l'Université**
**75340 Paris Cedex 07 (FR)**

(56) Documents cités:
**US-A- 4 797 696** **US-A- 5 933 216**

## Description

La présente invention a pour objet un dispositif d'élaboration d'une pluralité de faisceaux laser utilisables notamment mais non exclusivement dans un ensemble de traitement par faisceau laser d'une surface sensible à l'impact du faisceau laser.

On sait que pour la fabrication de circuits imprimés, une des étapes consiste à recouvrir la couche conductrice du circuit imprimé d'une couche de matériau de réserve et à insoler cette couche de réserve à travers un cliché donnant la forme des pistes conductrices que l'on veut obtenir sur le circuit imprimé. Après insolation de la couche de réserve, on procède à l'enlèvement des zones non-insolées correspondant aux portions de la couche conductrice que l'on veut enlever.

On sait également qu'il se développe une autre technique de réalisation de circuits imprimés dans laquelle la couche de réserve est impressionnée localement par l'impact d'un faisceau laser. L'impact du faisceau laser est commandé le plus souvent par un ensemble de balayage comportant un miroir polygonal rotatif combiné à un dispositif d'interruption commandé du faisceau laser qui est le plus souvent constitué par un modulateur acousto-optique.

Le nombre d'impacts de faisceaux laser étant bien sûr très important pour réaliser avec précision un panneau de circuit imprimé de grande dimension, il est bien sûr intéressant de pouvoir diviser la surface du panneau de circuit imprimé en un certain nombre de zones et de balayer simultanément chacune de ces zones à l'aide d'un faisceau laser afin de diminuer significativement le temps nécessaire à l'insolation de l'ensemble du panneau (voir par exemple US-A- 5 933 216).

Cependant, pour obtenir ce résultat, il est nécessaire que l'énergie de chaque faisceau laser se trouve dans une plage bien définie correspondant à la sensibilité du matériau constituant la couche de réserve vis à vis du rayonnement laser afin d'en modifier uniformément l'état en tout point d'impact.

En outre, on sait que les modulateurs acousto-optiques sont d'un coût d'autant plus élevé qu'ils doivent piloter un faisceau optique contenant une plage de longueurs d'onde d'autant plus grande. En outre, les modulateurs acousto-optiques sont adaptés à une certaine plage d'énergie, le dépassement de cette plage d'énergie entraînant une altération accélérée du fonctionnement du modulateur.

Enfin, l'efficacité de la modulation est d'autant plus grande que la plage de longueurs d'onde est étroite.

Un objet de la présente invention est de fournir un dispositif d'élaboration d'une pluralité de faisceaux laser, chaque faisceau laser appartenant à une plage limitée de longueurs d'onde et chaque faisceau laser contenant une énergie appartenant à une plage d'étendue relativement limitée.

Pour atteindre ce but selon l'invention, le dispositif d'élaboration d'une pluralité de faisceaux laser est caractérisé en ce qu'il comprend :

- une source laser émettant un faisceau initial contenant P longueurs d'onde ;
- un ensemble de division en longueurs d'onde pour diviser le faisceau initial en N faisceaux intermédiaires (N $\leq$ P) chaque faisceau intermédiaire (FI) contenant un groupe de longueurs d'onde comportant au moins une longueur d'onde ;
- N' ensembles de division en énergie (N' $\leq$ N) pour diviser un faisceau intermédiaire (FD) en ni faisceaux divisés, chacun des ni faisceaux divisés ayant sensiblement la même énergie, par quoi on obtient K faisceaux divisés (FD) avec :

$$K = N\text{-}N' + \sum_{i=1}^{i=N'} ni$$

On comprend que, en procédant tout d'abord à une division du faisceau laser émis par la source en un certain nombre de faisceaux intermédiaires, on obtient en sortie de ce diviseur des faisceaux appartenant à des plages de longueurs d'onde bien définies et sans recouvrement. On comprend également que dans la deuxième étape qui consiste à diviser en énergie au moins certains des faisceaux intermédiaires, on obtient finalement des faisceaux divisés qui contiennent une plage bien définie de longueurs d'onde et une énergie que l'on peut définir aisément.

De préférence, l'ensemble de division en longueurs d'onde comprend :

- un dispositif pour diviser ledit faisceau initial en P faisceaux unitaires (FI), chaque faisceau unitaire (FI) correspondant à une longueur d'onde ; et
- N moyens pour regrouper certains des P faisceaux unitaires appartenant à un même groupe de longueurs d'onde, les longueurs d'onde d'un même groupe étant disjointes des longueurs d'onde d'un autre groupe, par quoi on obtient N faisceaux intermédiaires.

Grâce à cette étape de recombinaison partielle des faisceaux laser monochromatiques, on recolinéarise les faisceaux monochromatiques appartenant à un même groupe. Ils pourront être traités par exemple par des modulateurs acousto-optiques ou plus généralement par des systèmes optiques avec sensiblement la même précision qu'un faisceau monochromatique.

Un autre objet de l'invention est de fournir un ensemble de traitement d'une surface sensible à un faisceau laser notamment de traitement de la couche de réserve réalisée sur la couche métallique d'un circuit imprimé en vue d'obtenir les pistes conductrices de ce circuit imprimé ou de traitement direct de la couche métallique.

L'ensemble de traitement se caractérise en ce qu'il comprend :

- un dispositif d'élaboration de faisceaux laser du type défini ci-dessus,
- K modulateurs acousto-optiques, chaque modulateur recevant un faisceau divisé, chaque modulateur étant adapté au groupe de longueurs d'onde du faisceau divisé qu'il reçoit et à son énergie,
- des moyens pour dévier chaque faisceau laser modulé pour que chaque faisceau laser modulé balaye une fraction de ladite surface.

D'autres caractéristiques et avantages de l'invention apparaîtront mieux à la lecture de la description qui suit de plusieurs modes de réalisation de l'invention donnés à titre d'exemples non limitatifs. La description se réfère aux figures annexées, sur lesquelles :

- la figure 1 est une vue simplifiée de l'ensemble du dispositif d'élaboration des faisceaux laser ;
- la figure 2 est une vue partielle du dispositif de la figure 1 correspondant à un mode perfectionné de mise en oeuvre ;
- la figure 3 illustre un exemple d'application du dispositif d'élaboration de faisceau laser pour la réalisation de circuit imprimé ; et
- la figure 4 illustre un mode de réalisation du diviseur de faisceau en énergie.

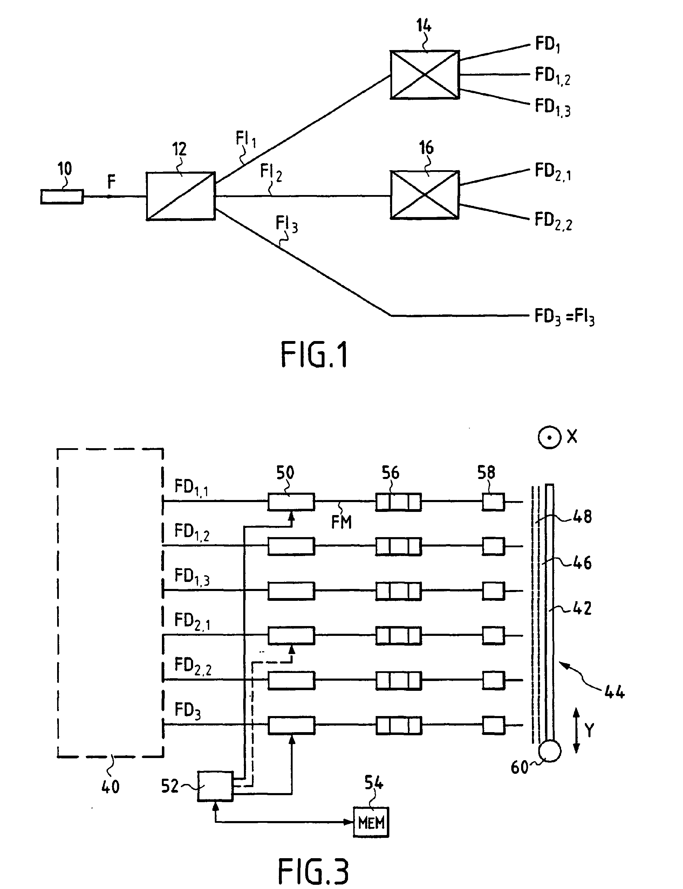

En se référant tout d'abord à la figure 1, on va décrire l'ensemble du dispositif d'élaboration de faisceau laser. Ce dispositif comporte une source laser 10 qui émet un faisceau F. Le faisceau F entre dans un diviseur de faisceaux laser en longueurs d'onde portant la référence 12. Ce diviseur 12 fournit à sa sortie des faisceaux laser intermédiaires $FI_1$, $FI_2$, $FI_3$. Il va de soi que selon la nature du faisceau laser initial F, on pourrait avoir un nombre différent de faisceaux intermédiaires. Certains des faisceaux intermédiaires, dans l'exemple particulier décrit, les faisceaux $FI_1$ et $FI_2$, sont appliqués à l'entrée d'un diviseur de faisceaux en puissance, respectivement référencés 14 et 16. Dans l'exemple particulier illustré, le diviseur 14 délivre trois faisceaux divisés $FD_{1,1}$, $FD_{1,2}$, $FD_{1,3}$. Chacun des faisceaux divisés contient 1/3 de la puissance contenue dans le faisceau intermédiaire $FI_1$. Le diviseur de faisceaux 16 délivre à sa sortie deux faisceaux divisés $FD_{2,1}$ et $FD_{2,2}$ contenant chacun la moitié de la puissance contenue dans le faisceau $FI_2$. Le faisceau $FI_3$ n'est pas divisé et fournit directement le faisceau divisé $FD_3$.

On comprend que cet ensemble d'élaboration de faisceaux laser divisés à partir d'un même faisceau laser initial F permet d'obtenir en sortie des faisceaux divisés qui contiennent des longueurs d'onde appartenant à une plage de longueurs d'onde relativement restreinte définie par le diviseur en longueurs d'onde 12 et dont les puissances peuvent toutes se situer dans une plage de puissance relativement restreinte en choisissant convenablement le regroupement des longueurs d'onde et la division en énergie des faisceaux intermédiaires en fonction de la puissance contenue dans chaque longueur du faisceau initial.

Dans un exemple préféré de mise en oeuvre de l'invention, la source laser 10 est un laser du type argon ionisé qui, dans le cas particulier, travaille entre les longueurs d'onde 333,6 nanomètres et 363,8 nanomètres en émettant sur les longueurs d'onde mentionnées ci-dessus une puissance de 7 watts en continu.

Les longueurs d'onde et les puissances des faisceaux divisés sont très bien adaptés aux matériaux constituant habituellement la couche de réserve.

Plus précisément, les longueurs d'onde émises avec leurs énergies sont indiquées ci-dessous.

|  | Longueurs d'onde (nm) | Puissance (W) |
|---|---|---|
| $FI_1$ | 333,6 | 0,75 |
|  | 334,4 | 0,72 |
|  | 335,8 | 0,41 |
| $FI_2$ | 351,1 | 2,10 |
|  | 351,4 | 0,90 |

(suite)

|  | Longueurs d'onde (nm) | Puissance (W) |
|---|---|---|
| $FI_3$ | 363,8 | 2,10 |

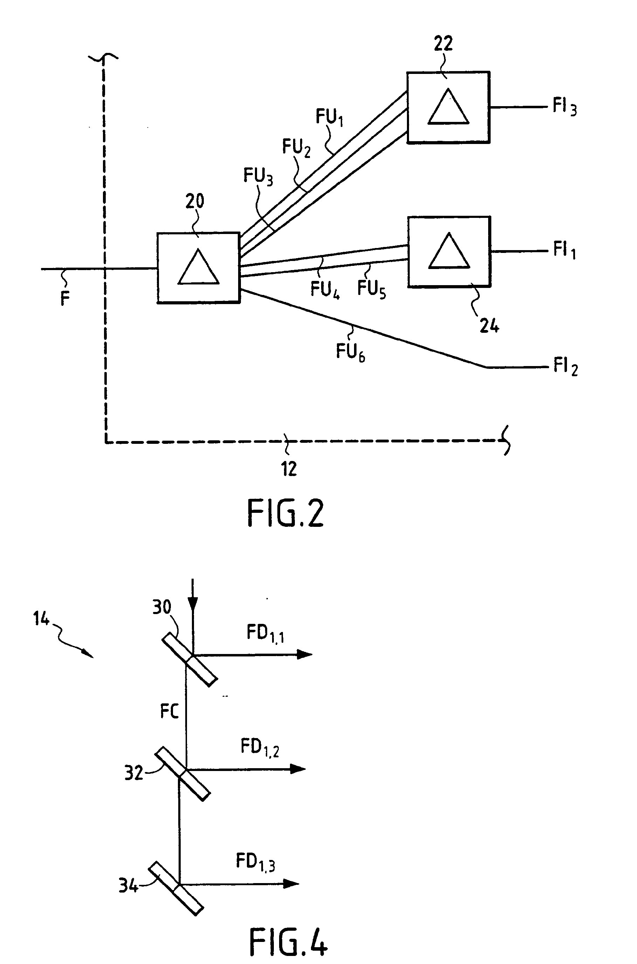

La figure 2 montre un mode préféré de réalisation du diviseur de faisceaux en longueurs d'onde. Ce diviseur 12 est constitué par un diviseur de faisceaux proprement dit 20, constitué par exemple par deux prismes qui délivre à sa sortie autant de faisceaux unitaires FU que le faisceau initial F contient de longueurs d'onde. Les faisceaux unitaires délivrés sont regroupés à l'aide de dispositifs de recombinaison tels que 22 et 24 pour obtenir à leur sortie les faisceaux intermédiaires FI contenant les plages de longueurs d'onde souhaitées. Dans l'exemple particulier correspondant au laser mentionné ci-dessus, les trois premières fréquences correspondant aux longueurs d'onde 333,6, 334,4 et 335,8 nanomètres sont regroupées dans le dispositif de recombinaison 22. Les longueurs d'onde 351,1 et 351,4 nanomètres sont recombinées dans le dispositif de recombinaison 24.

Dans le cas de l'exemple particulier, le faisceau intermédiaire $FI_1$ contient une puissance de 3 watts, le faisceau $FI_2$ contient une puissance de 2,1 watts et le faisceau $FI_3$ une puissance de 1,88 watt. Dans ce cas particulier, on trouve donc des faisceaux divisés $FD_{1,1}$ à $FD_3$ dont la puissance est comprise entre 1,1 watt et 1,88 watt. Cette plage de puissance est suffisamment restreinte pour les applications qui sont envisagées.

Sur la figure 4, on a représenté un exemple de réalisation du dispositif de division en énergie 14. Celui-ci comprend de façon connue une première lame semi-réfléchissante 30 qui reçoit le faisceau $FI_1$ pour délivrer le faisceau divisé $FD_{1,1}$ contenant 1/3 de la puissance du faisceau intermédiaire, la lame semi-réfléchissante 30 laissant passer un faisceau complémentaire FC contenant 66 % de la puissance. Une deuxième lame semi-réfléchissante 32 divise le faisceau FC en un deuxième faisceau divisé $FD_{1,2}$ et en un troisième faisceau divisé $FD_{1,3}$ de même puissance. Ce troisième faisceau divisé est renvoyé parallèlement aux deux premiers par un miroir 34.

Sur la figure 3, on a représenté de façon simplifiée un exemple d'application du dispositif d'élaboration de faisceaux laser à la réalisation d'une étape de fabrication d'un circuit imprimé. Sur cette figure, on a représenté par 40 le circuit diviseur de la figure 1 qui délivre les faisceaux divisés $FD_{1,1}$ à $FD_3$. Sur cette figure, on a également représenté de façon simplifiée le support isolant 42 du circuit imprimé 44. On a représenté également de façon simplifiée la couche de matériau conducteur, par exemple du cuivre 46 recouvert par la couche de réserve 48 dont l'état est altéré par l'impact des faisceaux laser. L'ensemble de traitement du circuit imprimé comporte, dans l'exemple particulier considéré, 6 modulateurs acousto-optiques 50 qui reçoivent chacun sur leur entrée un des faisceaux divisés FD. Les modulateurs acousto-optiques 50 sont commandés dans leur état passant ou non passant par un ensemble de commande 52 associé à une mémoire 54. Les faisceaux modulés FM qui sortent des modulateurs 50 sont dirigés vers des miroirs polygonaux rotatifs 56 qui permettent le balayage de la couche de réserve 48 selon une direction perpendiculaire au plan de la figure 3 que l'on appellera direction X sur une longueur correspondant à la zone relative à un faisceau laser. Le faisceau lumineux dévié par le miroir 56 traverse un système optique 58 de focalisation, ce dispositif optique redressant de plus le faisceau lumineux selon une direction orthogonale au circuit imprimé. Sur cette figure, on a également fait figurer des moyens 60 de déplacement du panneau selon la direction Y.

Il va de soi que le diviseur de faisceau laser pourrait être utilisé dans des installations de fabrication de panneaux de circuits imprimés dans lesquelles le faisceau laser permet l'ablation directe de la couche de réserve. Cette installation pourrait également être du type dans lequel il n'y a pas de couche de réserve et le faisceau laser permet l'ablation directe de la couche conductrice qui est par exemple réalisée en cuivre.

**Revendications**

1.   Dispositif d'élaboration d'une pluralité de faisceaux laser, **caractérisé en ce qu'**il comprend :

   - une source laser émettant un faisceau initial dans P longueurs d'onde,
   - un ensemble de division en longueurs d'onde pour diviser le faisceau initial en N faisceaux intermédiaires (N ≤ P) chaque faisceau intermédiaire (FI) contenant un groupe de longueurs d'onde comprenant au moins une longueur d'onde ;
   - N' ensembles de division en énergie (N' ≤ N) pour diviser un faisceau intermédiaire (FI) en n̲i faisceaux divisés, chacun des n̲i faisceaux divisés ayant sensiblement la même énergie, par quoi on obtient K faisceaux divisés (FD) avec

$$K = N-N' + \sum_{i=1}^{i=N'} ni$$

**2.** Dispositif selon la revendication 1, **caractérisé en ce que** l'ensemble de division en longueurs d'onde comprend :

- un dispositif pour diviser ledit faisceau initial en P faisceaux unitaires (FU), chaque faisceau unitaire (FU) correspondant à une longueur d'onde ; et
- N moyens pour regrouper certains des P faisceaux unitaires appartenant à un même groupe de longueurs d'onde, les longueurs d'onde d'un même groupe étant disjointes des longueurs d'onde d'un autre groupe, par quoi on obtient N faisceaux intermédiaires (FI).

**3.** Dispositif selon l'une quelconque des revendications 1 et 2, **caractérisé en ce que** ladite source laser est un laser du type Argon ionisé émettant dans la plage de longueurs d'onde de 333,6 nm à 363,8 nm et délivrant une puissance de 7 watts.

**4.** Dispositif selon la revendication 3, **caractérisé en ce que** P est égal à 6, N est égal à 3 et N' est égal à 2.

**5.** Dispositif selon la revendication 4, **caractérisé en ce que** $n_1$ est égal à 3 et $n_2$ est égal à 2.

**6.** Dispositif selon la revendication 5, **caractérisé en ce que** :

- la première plage de longueurs d'onde est comprise entre 333 et 335 nanomètres,
- la deuxième plage de longueurs d'onde contient des longueurs d'onde de 351,1 et 351,4 nanomètres ; et
- la troisième plage de longueurs d'onde contient la longueur d'onde de 363,8 nanomètres.

**7.** Application du dispositif de génération d'une pluralité de faisceaux laser selon l'une quelconque des revendications 1 à 6, à la réalisation d'un ensemble de traitement d'une surface sensible à un faisceau laser, **caractérisée en ce que** ledit ensemble comprend :

- un dispositif de génération de K faisceaux laser divisés selon l'une quelconque des revendications 1 à 6,
- K modulateurs acousto-optiques, chaque modulateur recevant un faisceau divisé chaque modulateur étant adapté au groupe de longueurs d'onde du faisceau divisé qu'il reçoit et à son énergie,
- des moyens pour dévier chaque faisceau laser modulé pour que chaque faisceau laser modulé balaye une fraction de ladite surface.

**Claims**

**1.** A device for generating a plurality of laser beams, the device being **characterised in that** it comprises:

- a laser source emitting an initial beam at P wavelengths;
- a wavelength splitter assembly for splitting the initial beam into N intermediate beams (N ≤ P), each intermediate beam (FI) containing a group of wavelengths comprising at least one wavelength; and
- N' energy splitter assemblies (N' ≤ N) for splitting an intermediate beam (FI) into $n_i$ divisional beams, each of the $n_i$ divisional beams having substantially the same energy, whereby K divisional beams (FD) are obtained with

$$K = N - N' + \sum_{i=1}^{i=N'} n_i$$

**2.** A device according to claim 1, **characterised in that** the wavelength splitter assembly comprises:

- a device for splitting said initial beam into P unit beams (FU), each unit beam (FU) corresponding to one wavelength; and

- N means for grouping together some of the P unit beams in a given group of wavelengths, the wavelengths of a group being disjoint from the wavelengths of another group, thereby obtaining N intermediate beams (FI).

3. A device according to claim 1 or 2, **characterised in that** said laser source is an ionized argon type laser emitting the wavelength range 333.6 nm to 363.8 nm, and delivering power at 7 watts.

4. A device according to claim 3, **characterised in that** P is equal to 6, N is equal to 3, and N' is equal to 2.

5. A device according to claim 4, **characterised in that** $n_1$ is equal to 3 and $n_2$ is equal to 2.

6. A device according to claim 5, **characterised in that**:

   - the first wavelength range is 333 nm to 335 nm;
   - the second wavelength range contains wavelengths of 353.1 nm and 351.4 nm; and
   - the third wavelength range contains the wavelength of 363.8 nm.

7. An application of the device for generating a plurality of laser beams according to any one of claims 1 to 6 to making equipment for treating a surface that is sensitive to a laser beam, the application being **characterised in that** said equipment comprises:

   - a device for generating K divisional laser beams according to any one of claims 1 to 6;
   - K acousto-optical modulators, each modulator receiving a divisional beam, each modulator being adapted to the group of wavelengths of the divisional beam it receives and being adapted to its energy; and
   - deflector means for deflecting each modulated laser beam so that each modulated laser beam scans a fraction of said surface.

**Patentansprüche**

1. Vorrichtung zur Darstellung einer Anzahl von Laserstrahlen,
   **dadurch gekennzeichnet, daß** sie umfasst:

   - eine Laserquelle, die einen anfänglichen Strahl in P Wellenlängen emittiert,
   - ein System zur Teilung in Wellenlängen, um den ersten Strahl in N Zwischenstrahlen (N ≤ P) zu teilen, wobei jeder Zwischenstrahl (FI) eine Gruppe von Wellenlängen enthält, die mindestens eine Wellenlänge umfaßt,
   - N' Systeme zur Teilung von Energie (N' ≤ N), um einen Zwischenstrahl (FI) in $\underline{n}i$ geteilte Strahlen zu teilen, wobei jeder der $\underline{n}i$ geteilten Strahlen im wesentlichen die gleiche Energie aufweist, wodurch K geteilte Strahlen (FD) erhalten werden mit

$$K = N - N' + \sum_{i=1}^{i=N'} ni$$

2. Vorrichtung nach Anspruch 1, **dadurch gekennzeichnet, daß** das System zur Teilung in Wellenlängen umfaßt:

   - ein System zur Teilung des anfänglichen Strahls in P einheitliche Strahlen (FU), wobei jeder einheitliche Strahl (FU) einer Wellenlänge entspricht, und
   - N Mittel zur Zusammenfassung bestimmter einheitlichen Strahlen, die der gleichen Gruppe von Wellenlängen angehören, wobei die Wellenlängen einer gleichen Gruppe von den Wellenlängen einer anderen Gruppe getrennt sind, wodurch N Zwischenstrahlen (FI) erhalten werden.

3. Vorrichtung nach einem der Ansprüche 1 und 2, **dadurch gekennzeichnet, dass** die Laserquelle ein Laser der Art ionisiertes Argon ist, der im Wellenlängenbereich 333,6 nm bis 363,8 nm emittiert wird und eine Leistung von 7 Watt liefert.

4. Vorrichtung nach Anspruch 3, **dadurch gekennzeichnet, dass** P gleich 6 ist, N gleich 3 ist und N' gleich 2 ist.

**5.** Vorrichtung nach Anspruch 4, **dadurch gekennzeichnet, dass** $n_1$ gleich 3 ist und $n_2$ gleich 2 ist.

**6.** Vorrichtung nach Anspruch 5, **dadurch gekennzeichnet, dass**:

- der erste Wellenlängenbereich zwischen 333 und 335 Nanometern liegt,
- der zweite Wellenlängenbereich Wellenlängen von 351,1 und 351,4 Nanometern aufweist und
- der dritte Wellenlängenbereich die Wellenlänge von 363,8 Nanometern enthält.

**7.** Verwendung der Vorrichtung zur Darstellung einer Anzahl von Laserstrahlen nach einem der Ansprüche 1 bis 6 zur Ausbildung eines Systems zur Behandlung einer Fläche, die empfindlich auf einen Laserstrahl reagiert, **dadurch gekennzeichnet, dass** das System umfasst :

- eine Vorrichtung zur Darstellung von K Laserstrahlen, die nach einem der Ansprüche 1 bis 6 geteilt sind,
- K akusto-optische Modulatoren, wobei jeder Modulator einen geteilten Strahl empfängt, wobei jeder Modulator an die Wellenlängengruppe des geteilten Strahls, den er empfängt und an seine Energie angepasst ist,
- Mittel zur Ablenkung jedes modulierten Laserstrahls, damit jeder modulierte Laserstrahl einen Bruchteil der Fläche abtastet.

FIG.1

FIG.3

FIG.2

FIG.4